Europäisches Patentamt

European Patent Office

Office européen des brevets

(19)

(11) Veröffentlichungsnummer: **0 151 784**
**B1**

(12) **EUROPÄISCHE PATENTSCHRIFT**

(45) Veröffentlichungstag der Patentschrift: **16.01.91**

(51) Int. Cl.⁵: **H 03 H 7/48**

(21) Anmeldenummer: **84116023.7**

(22) Anmeldetag: **21.12.84**

(54) **Hochfrequenz-Verteileinrichtung.**

(30) Priorität: **14.02.84 DE 3405113**

(43) Veröffentlichungstag der Anmeldung:
**21.08.85 Patentblatt 85/34**

(45) Bekanntmachung des Hinweises auf die
Patenterteilung:
**16.01.91 Patentblatt 91/03**

(84) Benannte Vertragsstaaten:
**AT BE CH DE LI NL SE**

(56) Entgegenhaltungen:
**WO-A-81/03588**
**US-A-2 115 059**
**US-A-3 146 409**
**US-A-3 559 110**
**US-A-4 275 365**

(73) Patentinhaber: **Richard Hirschmann GmbH & Co.**
**Richard-Hirschmann-Strasse 19 Postfach 110**
**D-7300 Esslingen a.N. (DE)**

(72) Erfinder: **Wendel, Wolfgang, Dipl.-Ing.**
**Steinbruchstrasse 62**
**D-7316 Köngen (DE)**

(74) Vertreter: **Stadler, Heinz, Dipl.-Ing.**
**Richard Hirschmann Radiotechnisches Werk**
**Richard-Hirschmann-Strasse 19**
**D-7300 Esslingen a.N. (DE)**

EP 0 151 784 B1

**Beschreibung**

Die Erfindung betrifft eine Einrichtung nach dem Oberbegriff des Patentanspruchs.

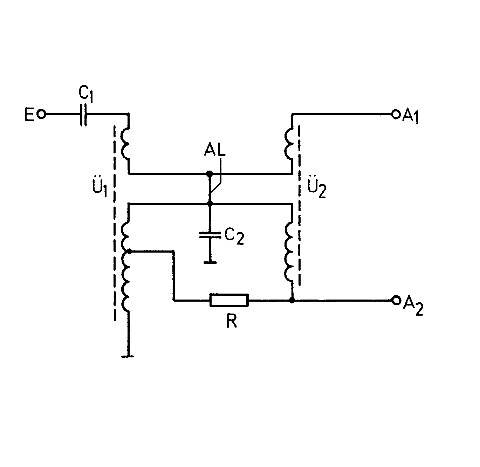

Ein derartige Hochfrequenz-Verteileinrichtung ist z.B. aus der US—PS 4,275,365 bekannt (Fig. 3), wobei der Differentialübertrager die Hochfrequenzenergie unsymmetrisch aufteilt und der Entkopplungswiderstand zwischen dem hochohmigeren Ausgang 23 und der leitenden Verbindung der beiden Übertrager, also parallel zum größeren Spulenteil 28b des Differentialübertragers eingeschaltet ist.

Im Vergleich zur Parallelschaltung des Entkopplungswiderstands zur gesamten Spule des Differentialübertragers (Einschaltung zwischen dessen Ausgängen), wie diese beispielsweise aus Fig. 1 der genannten Druckschrift oder der DE 28 07 327 B1 bekannt ist, sind damit bei unsymmetrischer Aufteilung der Hochfrequenzenergie etwas günstigere Werte für die Koppeldämpfung zwischen den Ausgängen und die Rückflußdämpfung an allen Anschlüssen erreichbar. Allerdings ist bei dieser Lösung der Entkopplungswiderstand mit seinem einen Anschluß stets mit der Anzapfung am Anpaßübertrager verbunden, die wegen der angestrebten Eingangsanpassung fest vorgegeben ist. Damit ist jedoch im vorgesehenen Betriebsfrequenzbereich weder eine optimale Entkopplung der Ausgänge noch eine gute Anpassung des mit dem Entkopplungswiderstand verbundenen Ausgangsanschlusses erreichbar. Die Werte genügen zwar für viele Anwendungen in Einzel- und kleineren Gemeinschafts-Antennenanlagen, erfüllen jedoch—zumindest hinsichtlich der Entkopplung-—bei weitem nicht die bei Verwendung in Breitband-Kabelanlagen bestehende Forderung der Deutschen Bundespost (Richtlinie 1 R 8—15), gemäß der zwischen benachbarten Dosenanschlüssen der gleichen Frequenz eine Koppeldämpfung von ≥40 dB im Frequenzbereich 47—300 MHz gewährleistet sein muß. Die Einsatzmöglichkeiten der bekannten Verteileinrichtung sind somit wesentlich eingeschränkt.

Der Erfindung liegt die Aufgabe zugrunde, eine Hochfrequenz-Verteileinrichtung der eingangs genannten Art zu schaffen, bei der auf möglichst einfache und kostengünstige Weise in einem möglichst großen Frequenzbereich und bei guter Anpassung aller Anschlüsse die angeführte Entkopplungsforderung erfüllt ist.

Diese Aufgabe wird durch die kennzeichnenden Merkmale des Patentanspruchs gelöst.

Mit diesem erfindungsgemäßen Aufbau ist ohne Bauteilemehraufwand gegenüber dem angeführten Stand der Technik (nur ein ohm'scher Widerstand) im gesamten VHF/UHF-Bereiche (47—790 MHz) eine Koppeldämpfung zwischen den beiden Ausgängen der Verteileinrichtung von ≥40 dB, sowie eine Rückflußdämpfung von $a_R \geq 20$ dB an allen Anschlüssen erreichbar. Die Entkopplung zwischen zwei angeschlossenen Durchgangsdosen im gleichen Frequenzbereich beträgt damit bei symmetrischer Aufteilung ≥43 dB, so daß sich die erfindungsgemäße Verteileinrichtung auch für den direkten Anschluß (ohne Verteiler) von Enddosen eignet.

Der erfindungsgemäße Aufbau ist nicht nur für Schaltungen mit gewickelten, sondern vor allen Dingen auch solchen mit in Drucktechnik ausgeführten Übertragern geeignet, weil bei diesen die Fertigungstoleranzen minimal und keine besonderen Aufwendungen zur Schaffung von Anzapfpunkten nötig sind, so daß die angeführten Entkopplungs- und Anpassungswerte auch in der Serienfertigung sicher und ohne Abgleich gewährleistet sind.

Die Figur zeigt ein Prinzipschaltbild eines für den Einsatz in Antennensteckdosen mit einer Anschlußdämpfung von 6 dB vorgesehenen Ausführungsbeispiels der erfindungsgemäßen Verteileinrichtung. Dabei ist der Übersichtlichkeit halber die jeweils an einem der Ausgänge angeschlossenen Weiche zur Trennung der Rundfunk- und Fernsehbereiche nicht dargestellt.

Die Zweifach-Verteileinrichtung weist jeweils einen zwischen Eingang E und Masse liegenden Anpaßübertrager $\ddot{U}_1$ und einen die beiden Ausgänge $A_1$, $A_2$ verbindenden Differentialübertrager $\ddot{U}_2$ auf. Diese sind zur Vermeidung unnötiger Verluste in bekannter Weise als Sparübertrager mit in Rohrkernen verlaufenden Wicklungen kleiner Windungszahl ausgeführt. Der Ausgang $A_1$ ist zum Anschluß des Eingangs der Verteileinrichtung einer weiteren Antennensteckdose vorgesehen, der Ausgang $A_2$ zum Anschluß einer Weiche zur Auftrennung der Rundfunk- und Fernsehbereiche.

Wegen der ungleichen Windungszahlen der Wicklungen des Anpaßübertragers $\ddot{U}_1$ sind auch die Ströme in seinen beiden Ausgangsleitungen nicht gleich und würden damit eine ungleichmäßige Energieaufteilung bewirken. Zur Vermeidung dieses unerwünschten Effektes ist in bekannter Weise durch eine Ausgleichsleitung AL zwangsweise ein Potentialausgleich zwischen den beiden, die Teilwicklungen der beiden Übertrager $\ddot{U}_1$, $\ddot{U}_2$ verbindenden Leitungen herbeigeführt.

Zur Verbesserung der Anpassungswerte bei tiefen Frequenzen ist zwischen den Eingang E und dem Anpaßübertrager $\ddot{U}_1$ ein Kondensator $C_1$ eingeschaltet. Ein zwischen die Ausgleichsleitung AL und Masse eingeschalteter Kondensator $C_2$ bewirkt in bekannter Weise eine Erhöhung der oberen Grenzfrequenz.

Der Differentialübertrager $\ddot{U}_2$ teilt die Hochfrequenzleistung derart ungleichmäßig auf, daß die Anschlußdämpfung am Ausgang $A_2$ 6 dB und die Durchgangsdämpfung am Ausgang $A_1$ 2 dB beträgt.

Zur breitbandigen Verbesserung der Koppeldämpfung zwischen den Ausgängen $A_1$, $A_2$ im Betriebsfrequenzbereich 47—790 MHz und Gewährleistung einer hohen Rückflußdämpfung an allen Anschlüssen der Verteileinrichtung ist ein ohm'scher Widerstand R von 270 Ω zwischen einem Anschlußpunkt des Anpaßübertragers $\ddot{U}_1$ nach dessen von der Masseseite her zweiten Windung und dem Ausgang $A_2$ eingeschaltet.

Der Anpaßübertrager $\ddot{U}_1$ ist so aufgebaut, daß unter Berücksichtigung der Eingangsimpedanz des Differentialübertragers $\ddot{U}_2$ und des ohm'schen Widerstands R der Eingangsanschluß E angepaßt ist. Bei deiser Verteileinrichtung ist mit geringsmöglichem Bauteileaufwand über einen sehr größen Frequenzbereich eine Koppeldämpfung zwischen den beiden Ausgängen $A_1$, $A_2$ von $\geq 40$ dB, sowie eine Rückflußdämpfung an allen Anschlüssen von $\geq 20$ dB erzielt.

Diese günstigen Werte werden ohne besondere Abgleichmaßnahmen auch in der Serienfertigung gehalten, insbesondere deshalb, weil die beiden Übertrager in Drucktechnik ausgeführt sind und dadurch äußerst geringe Fertigungstoleranzen aufweisen und keine besonderen Maßnahmen zur Herstellung von Anschlußpunkten erfordern.

**Patentanspruch**

Einrichtung zum Aufteilen von Hochfrequenzenergie im VHF/UHF-Bereich auf zwei voneinander entkoppelte, impedanzmäßig angepaßte Ausgänge, mit je einem jeweils eine Wicklung mit Anzapfung aufweisenden Anpaß- und Differentialübertrager, wobei die aufzuteilende Hochfrequenzenergie an den beiden Wicklungsenden des Anpaßübertragers angeschlossen ist und die Ausgänge an den beiden Wicklungsenden des Differentialübertragers angeschlossen sind und wobei die Anzapfungen miteinander leitend verbunden sind, sowie einem zwischen dem Anpaßübtertrager und bei symmetrischer Verteilung einem der beiden Ausgänge, bei unsymmetrischer Verteilung dem hochohmigeren Ausgang eingeschalten ohmschen Entkopplungswiderstand, dadurch gekennzeichnet, daß der Anschlußpunkt des Entkopplungswiderstands (R) am Anpaßübertrager ($\ddot{U}_1$) verschieden von dessen Anzapfung ist und daß der Ort des Anschlußpunkts und die Größe des Entkopplungswiderstands (R) derart gewählt sind, daß sowohl die Entkopplung der beiden Ausgänge ($A_1$, $A_2$) als auch die Anpassung des hochohmigeren Ausgangs ($A_2$) einen optimalen Wert aufweisen.

**Revendication**

Dispositif de distribution de hautes fréquences dans la gamme VHF/UHF vers deux sorties découplées, adaptées en impédance, comportant chacune un transformateur d'adaptation et un transformateur différentiel présentant chacun un enroulement avec une prise, tandis que les hautes fréquences à distribuer sont connectées aux deux extrémités de l'enroulement du transformateur d'adaptation et que les sorties sont connectées aux deux extrémités de l'enroulement du transformateur différentiel et que les prises sont connectées l'une à l'autre par une liaison conductrice, ainsi qu'avec une résistance ohmique de découplage connectée entre le transformateur d'adaptation et, en cas de distribution symétrique, l'une des deux sorties, ou bien, en cas de distribution asymétrique, la sortie à haute résistance, caractérisé en ce que le point de raccordement de la résistance de découplage (R) au transformateur d'adaptation ($\ddot{U}1$) est différent de sa prise et que la position du point de branchement et la taille de la résistance de découplage (R) sont choisies de manière à ce que le découplage des deux sorties ($A1$, $A2$) ainsi que l'adaptation de la sortie à haute résistance ($A2$) présentent une valeur optimale.

**Claim**

Network for distribution of high-frequency energy in the VHF-UHF range to two impedance-adapted outputs decoupled from one another, having an adapter transformer and a differential transformer, each with a winding and pickup, wherein the high-frequency energy to be distributed is connected to the two ends of the windings of the adapter transformer, and the outputs are connected to the two ends of the windings and the differential transformer, and the pickups are conductively connected to one another, and having an ohmic decoupling resistor incorporated between the adapter transformer and, given symmetrical distribution, one of the two outputs, and given asymmetrical distribution the higher-impedance output, characterized in that the connection point of the decoupling resistor (R) at the adapter transformer $O_1$) is different from the pickup of this resistor, and that the location of the connection point and the resistance of the decoupling resistor (R) are selected such that both the decoupling of the two outputs ($A_1$, $A_2$) and the adaptation of the higher-impedance output ($A_2$) have an optimal value.